# EUROPÄISCHE PATENTSCHRIFT

(11) **EP 1 292 030 B1**
(45) Veröffentlichungstag und Bekanntmachung des Hinweises auf die Patenterteilung: **18.01.2006**
(21) Anmeldenummer: 02018315.8
(22) Anmeldetag: 14.08.2002
(51) Int. Cl.: H03K 17/95

(54) **Induktiver Näherungssensor**
Inductive proximity sensor
Capteur de proximité inductif

(30) Priorität: 07.09.2001 DE 10143900
(43) Veröffentlichungstag der Anmeldung: 12.03.2003
(73) Patentinhaber: SICK AG, 79183 Waldkirch (DE)
(72) Erfinder: Machul, Olaf, Dr., 79104 Freiburg (DE)
(74) Vertreter: Ludewigt, Christoph

(56) Entgegenhaltungen:
- FR-A- 2 604 251
- US-A- 6 031 430
- MOSSBAUER K: "INDUCTIVE PROXIMITY SWITCH" ELEKTOR ELECTRONICS, ELEKTOR PUBLISHERS LTD. CANTERBURY, GB, Bd. 18, Nr. 206, 1. Dezember 1992 (1992-12-01), Seite 67, XP000320907 ISSN: 0268-4519

## Beschreibung

Die Erfindung betrifft einen induktiven Näherungssensor mit einem elektrischen Schwingkreis und einer hiermit gekoppelten elektrischen Energiequelle zum Ausgleich der Verluste im Schwingkreis.

Induktive Näherungsensoren finden allgemein Anwendung in der Automatisierungstechnik zur Bestimmung von Betriebszuständen in Automatisierungsanlagen, Fertigungssystemen (z.B. Schweißrobotern) und verfahrenstechnischen Anlagen. Näherungsschalter bewerkstelligen dabei die Detektion der An- bzw. Abwesenheit von elektrisch leitfähigen Werkstücken-oder Maschinenteilen. Neben der Positionserfassung sind ebenfalls Applikationen wie beispielsweise Drehzahl- und Geschwindigkeitsmessungen an rotierenden oder translatorisch bewegten Teilen denkbar.

Induktive Näherungssensoren wie aus Dokument US 6 031 430 A bekannt, besitzen eingangsseitig einen verlustbehafteten LC-Schwingkreis (Oszillator), dessen Verlustwiderstand Rp beispielsweise durch Annäherung eines elektrisch leitfähigen Mediums gezielt beeinflußt werden kann. Mittels einer mit dem Schwingkreis gekoppelten Auswerteschaltung kann eine entsprechende Veränderung des Verlustwiderstandes Rp detektiert werden, um beispielsweise im Falle eines Näherungsschalters ein Schaltsignal auzulösen.

Die mit dem Schwingkreis gekoppelte Energiequelle dient zum Ausgleich der Verluste, um die Schwingung aufrechtzuerhalten. Hierfür wird beispielsweise ein elektrischer Kompensationsstrom in den Schwingkreis eingespeist. Die mitgekoppelte Energiequelle verhält sich somit wie ein negativer Widerstand, da die über den Schwingkreis abfallende Spannung und der zurückgekoppelte Kompensationsstrom gemäß den Bezugspfeilkonventionen entgegengesetzt gerichtet sind.

Bei induktiven Näherungssensoren können elektromagnetische Störungen, die durch den Einsatz in einer überaus rauhen Industrieumgebung hervorgerufen werden, aufgrund der Ausführung des Sensorelementes als LC-Schwingkreis induktiv oder kapazitiv einkoppeln. Magnetische Einkopplungen wirken sich in Form einer Schwebung auf der Schwingkreisamplitude aus.

Im Gegensatz dazu wird bei kapazitiven Einkopplungen - je nach Phasenlage der Einkopplung - dem Schwingkreis Energie entzogen oder hinzugefügt, was sich zeitweilig in einer unerwünschten Änderung der Schwingkreisamplitude auswirkt, da die kapazitiv ein- bzw. ausgekoppelte Energie nur über den Verlustwiderstand R_{P} wieder zu- oder abgeführt werden kann. Die ein- bzw. ausgekoppelte Energiemenge E hängt dabei ebenfalls von dem Verlustwiderstand R_{P} bzw. der Güte Q des LC-Schwingkreises ab. Je kleiner die Güte Q ist, desto besser kann Energie in den Schwingkreis ein- bzw. ausgekoppelt werden. Die Zeitkonstante T für die Relaxation der eingekoppelten Störung bzw. der zusätzlich hinzugeführten Energie E ist daher von dem Verlustwiderstand R_{P} des Schwingkreises abhängig. Je höher der Verlustwiderstand, desto schlechter kann die eingekoppelte Energie wieder abfließen. Analog kann ausgekoppelte Energie am schlechtesten bei niedrigem Verlustwiderstand wieder aufgebaut werden.

Derartig eingekoppelte Störungen können daher bei bekannten Näherungssensoren zu einem unbeabsichtigten Auslösen des Schaltsignals führen oder ein Auslösen des Schaltsignals bei angenähertem Ansprechelement verhindern. Mit Hilfe derzeitig bekannten Signalverarbeitungsmethoden können Fehlschaltungen zwar erfolgreich unterdrückt werden, allerdings nur unter erheblicher Reduzierung der nutzbaren Signalbandbreite.

Es ist eine Aufgabe der Erfindung Fehlfunktionen eines Näherungssensors unter Störeinflüssen zu unterdrücken ohne die nutzbare Signalbandbreite zu reduzieren.

Diese Aufgabe wird für einen Näherungssensor der eingangs genannten Art dadurch gelöst, daß zur aktiven Kompensation von in den Schwingkreis eingekoppelten Signaländerungen ein Filter vorgesehen ist, das eingangsseitig mit dem Schwingkreis und ausgangsseitig mit der Energiequelle gekoppelt ist. Signaländerungen können hervorgerufen werden durch kapazitive Störeinkopplungen oder auch durch Annäherung eines zu detektierenden Gegenstandes.

Erfindungsgemäß ist über das Filter ein zusätzlicher Kopplungsweg vorgesehen, der eine aktive Unterstützung der Relaxation der im Schwingkreis eingekoppelten Signaländerungen ermöglicht. Diese aktive Unterstützung der Dämpfung der Signaländerung kann dadurch erfolgen, daß die Menge der Energie welche die elektrische Energiequelle dem Schwingkreis zur Aufrechterhaltung der Resonanzschwingung zuführt, in Abhängigkeit von dem Ausgangssignal des Filters zeitweise gezielt erhöht oder verringert wird.

Der erfindungsgemäße Näherungssensor hat also den Vorteil, daß die Relaxation der Signaländerung erheblich beschleunigt wird. Dadurch kann die Schaltfrequenz, also die Frequenz mit der Gegenstände detektiert werden können, erheblich erhöht werden und gleichzeitig wird die Relaxationszeit bei Störungen erheblich verkürzt. Dadurch wird der Zeitraum innerhalb dessen eine Annäherung des Ansprechelements ungestört detektiert werden kann entsprechend verlängert.

Ein weiterer Vorteil der Erfindung besteht darin, daß die erläuterte aktive Unterstützung der Relaxation mit minimalem zusätzlichen baulichen Aufwand realisiert werden kann, da die Energiequelle, die zur Unterstützung der Relaxation herangezogen wird, ohnehin vorhanden ist.

Wie erläutert, ist es von Vorteil, wenn das das Ausgangssignal des Filters innerhalb der Energiequelle als zusätzliches Regelsignal verwendet wird, zur Änderung der Energiezufuhr an den Schwingkreis. Mit anderen Worten ist der betreffende Regeleingang der Energiequelle mit dem darin ohnehin vorhandenen Verstärker so verschaltet, daß das Signal des Filters zu einer Erhöhung bzw, Verringerung der periodischen Energiezufuhr an den Schwingkreis führt.

Der Begriff "Filter" ist im Zusammenhang mit der Erfindung im weitesten Sinne zu verstehen. Das Filter kann als analoges, digitales elektrisches bzw. elektronisches Filter ausgebildet sein, beispielsweise als Hochpaß, Tiefpaß oder Bandpaß, oder als Kombination hiervon mit beliebiger Übertragungscharakteristik.

Für die erläuterte zusätzliche Regelung der Energiezufuhr an den Schwingkreis ist das Filter ausgangsseitig direkt oder indirekt mit wenigstens einem Regelungseingang der Energiequelle verbunden. Beispielsweise kann zwischen dem Ausgang des Filters und der Energiequelle eine für die weitere Verarbeitung des Ausgangssignals des Filters erforderliche Signalumwandlung erfolgen, insbesondere eine Spannungs-/Strom-Konvertierung.

Die Energiequelle kann eingangsseitig direkt oder indirekt mit dem Schwingkreis gekoppelt sein, um die Resonanzfrequenz aufzunehmen und sie kann ausgangsseitig mit dem Schwingkreis verbunden sein, um die Energie zur Aufrechterhaltung der Schwingung zuführen zu können.

Das Filter kann auch in die Energiequelle integriert sein, solange der erläuterte zusätzliche Kopplungsweg realisiert ist.

Vorzugsweise ist das Filter und/oder die Energiequelle zumindest teilweise in CMOS-Bauweise realisiert.

Die Erfindung wird nachfolgend beispielhaft unter Bezugnahme auf die Zeichnung erläutert. In der Zeichnung zeigen:

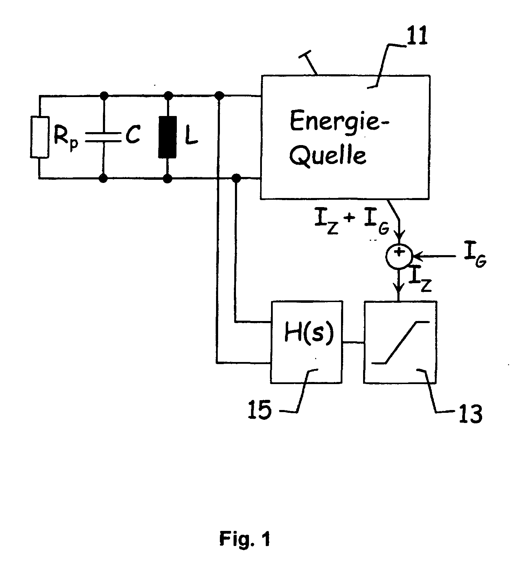

- Fig. 1: ein Blockschaltbild eines Teils des erfindungsgemäßen Näherungssensors;
- Fg. 2: eine Signaländerung bei Einfluss einer Störung;
- Fg.3: eine Signaländerung bei Annäherung eines zu detektierenden Gegenstandes.

Ein erfindungsgemäßer induktiver Näherungssensor, von dem in Fig. 1 ein Teil in einem Blockschaltbild dargestellt ist, besitzt eingangsseitig einen verlustbehafteten LC-Schwingkreis, bestehend aus einer Spule L und einer Kapazität C, dessen Verlustwiderstand R_{P} beispielsweise durch Annäherung eines elektrisch leitfähigen Mediums gezielt beeinflußt werden kann. Mittels einer mit dem Schwingkreis gekoppelten und nicht näher dargestellten Auswerteschaltung kann eine entsprechende Veränderung des Verlustwiderstandes R_{P} detektiert werden, um beispielsweise ein Schaltsignal auszulösen.

Eine mit dem Schwingkreis gekoppelte Energiequelle 11, beispielsweise ein Spannungs-/Strom-Wandler, insbesondere ein Transkonduktanzverstärker, dient zum Ausgleich der Verluste, um die Schwingung aufrechtzuerhalten. Hierfür wird ein elektrischer Kompensationsstrom I_{G} in den Schwingkreis eingespeist. Die mitgekoppelte Energiequelle 11 verhält sich somit wie ein negativer Widerstand -R_{P}, da die über den Schwingkreis abfallende Spannung und der Kompensationsstrom I_{G} entgegengesetzt gerichtet sind.

Erfindungsgemäß ist vorgesehen, dass im Falle einer Signaländerung mit Hilfe der Energiequelle 11, die eingekoppelte Energie bzw, der negative Widerstand -R_{P} der mitgekoppelten Energiequelle 11 derart nachgeregelt wird, dass die Zeitkonstante T zur Relaxation der Störung deutlich verkürzt wird.

Die Relaxationszeit T kann allerdings nur dann verkürzt werden, wenn eingekoppelte Energie schneller abgebaut und ausgekoppelte Energie wieder schneller aufgebaut werden kann. Dazu wird der negative Widerstand -Rp der Energiequelle 11, der für die Kompensation der Schwingkreisverluste zuständig ist, bei zusätzlich eingekoppelter Energie zeitweise verkleinert und bei ausgekoppelter Energie zeitweise vergrößert. Das negative Widerstandsverhalten der Energiequelle 11 kann gezielt über einen zusätzlichen Strom I_{Z} beeinflußt werden. Dazu werden die Signaländerungen der Energiequelle 11 über ein Filter 15, das eine entsprechend geeignete Übertragungsfunktion H(s) enthält, als Regelsignal einer Zusatzstromquelle 13, die den zusätzlichen Strom I_{Z} liefert, mitgeteilt.

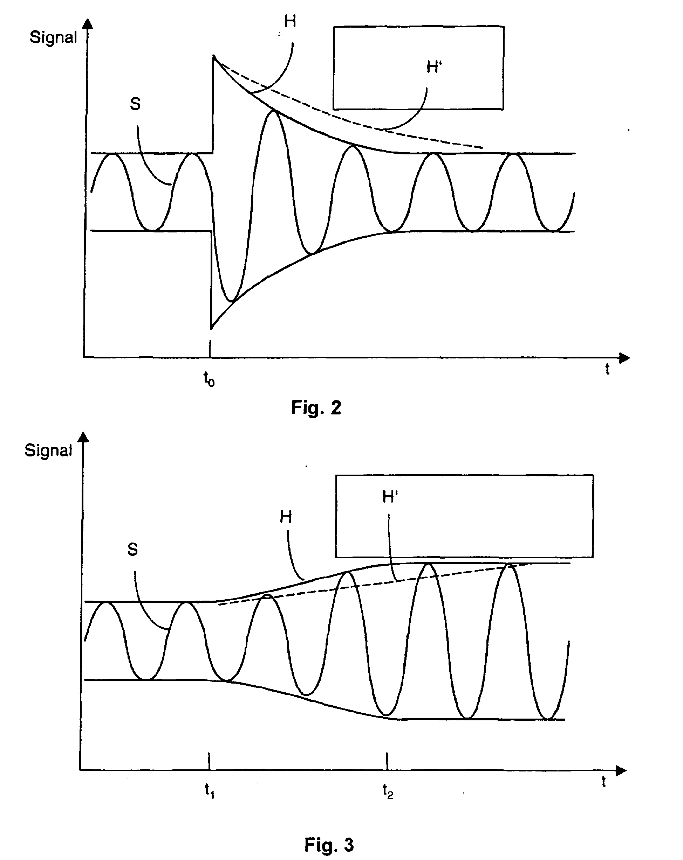

Anhand der Fig. 2 und 3 sei die Funktionsweise des erfindungsgemäßen Näherungssensors dargestellt, in denen jeweils das Signal, also die Schwingung S und deren Einhüllende H bzgl. zwei unterschiedlicher Situationen über der Zeit dargestellt ist.

In Fig. 2 ist der Signalverlauf dargestellt, wenn bei t = t₀ eine kurzzeitige Störung auftritt. Die Amplitude der Schwingung ist zu diesem Zeitpunkt durch die Einkopplung der Störung stark erhöht. Im weiteren Verlauf wird diese Störung relaxieren und die Amplitude auf den ursprünglichen Wert wieder absinken. Die Signaländerung aufgrund der Störung wird von dem Filter 15 erkannt und entsprechend der Übertragungsfunktion H(s) ein Regelsignal bereitgestellt, dass der Zusatzstromquelle 13 zugeführt wird. Der zusätzliche Strom I_{Z} wird zusammen mit dem Kompensationsstrom I_{G} der Energiequelle 11 zugeführt, wodurch der negative Widerstand der Energiequelle 11 derart geändert wird, dass die Signaländerung schneller abklingt. Die schnellere Relaxation ist in Fig. 2 dargestellt, indem zusätzlich zur Einhüllenden H eine Einhüllende H' dargestellt ist, die qualitativ den Verlauf der Signaländerung darstellt, wenn kein zusätzlicher Strom I_{Z} eingespeist würde.

In Fig. 3 ist ein Signalverlauf dargestellt, bei dem zu einem Zeitpunkt t = t₁ ein zu detektierender Gegenstand in den Wirkbereich des erfindungsgemäßen Näherungssensors eingebracht wird. Bei t = t₂ hat das System sich auf die durch die Anwesenheit des Gegenstandes verursachte, neue Amplitude eingeschwungen. Die Zeitdifferenz t₂ - t₁, also die Relaxationszeit für diese Situation, wird erfindungsgemäß wiederum verkürzt durch Bereitstellung des Zusatzstroms I_{z} und damit bewirkte Änderung des negativen Widerstandes -R_{P} der Energiequelle 11. Ohne die zusätzliche Regelung über den Zusatzstrom I_{Z} wäre die Relaxationszeit t₂ - t₁ verlängert, wie in Fig. 3 durch die gestrichelt dargestellte Linie H' schematisch angedeutet ist.

Der erfindungsgemäße Näherungssensor hat also den Vorteil, das die Relaxation einer eingekoppelten Störung erheblich beschleunigt wird. Dadurch wird der Zeitraum, innerhalb dessen eine Annäherung des Ansprechelements ungestört detektiert werden kann, entsprechend verlängert.

Durch den erfindungsgemäßen Näherungssensor wird darüber hinaus die nutzbare Schaltfrequenz erhöht, da durch die zeitweilig aktive Veränderung des Verlustwiderstandes durch die Energiequelle bei Annäherung eines Targets die im LC-Schwingkreis gespeicherte Energie schneller abgebaut und bei Entfernung des Targets die Energie schneller aufgebaut werden kann.

Ein weiterer Vorteil der Erfindung besteht darin, dass die erläuterte Unterstützung der Relaxation mit minimal, zusätzlichem Aufwand realisiert werden kann, da die Energiequelle, die zur Unterstützung der Relaxation herangezogen wird, ohnehin zur Aufrechterhaltung der Schwingung benötigt wird.

Das Filter 15 kann als Hoch-, Band- oder Tiefpaß oder einer Kombination aus diesen in analoger oder digitaler Ausführung realisiert sein. Vorzugsweise ist das Filter 15 und/oder die Energiequelle 11 in CMOS-Bauweise realisiert.

## Patentansprüche

1. Induktiver Näherungssensor mit einem elektrischen Schwingkreis (L, C, Rp) und einer hiermit gekoppelten elektrischen Energiequelle (11) zum Ausgleich der Verluste im Schwingkreis, wobei zur Kompensation von in den Schwingkreis eingekoppelten Signaländerungen ein Filter (15) vorgesehen ist, das eingangsseitig mit dem Schwingkreis (L, C, Rp) und ausgangsseitig mit der Energiequelle (11) gekoppelt ist, **dadurch gekennzeichnet, daß** innerhalb der Energiequelle (11) das Ausgangssignal des Filters (15) verwendbar ist zur Änderung der Energiezufuhr oder der Stromzufuhr und damit zur aktiven Kompensation von eingekoppelten Signaländerungen.

2. Näherungssensor nach einem der vorhergehenden Ansprüche, **dadurch gekennzeichnet, daß** das Filter (15) als Hochpaß, Tiefpaß, Bandpaß oder Kombination hiervon ausgebildet ist.

3. Näherungssensor nach einem der vorhergehenden Ansprüche, **dadurch gekennzeichnet, daß** zwischen den Ausgängen des Filters (15) und einem Steuereingang der Energiequelle (11) ein Spannungs- /Strom-Wandler (13) geschaltet ist, zur Änderung der zusätzlichen Energie- oder Stromzufuhr.

4. Näherungssensor nach einem der vorhergehenden Ansprüche, **dadurch gekennzeichnet, daß** die Energiequelle (11) einen Spannungs-/Strom-Wandler, insbesondere einen Transkonduktanzverstärker aufweist.

5. Näherungssensor nach einem der vorhergehenden Ansprüche, **dadurch gekennzeichnet, daß** eine Auswerteschaltung vorgesehen ist, die mit dem Schwingkreis gekoppelt ist.

## Claims

1. Inductive proximity sensor comprising an oscillatory circuit (L, C, Rp), an electric energy source (11) coupled to the oscillatory circuit for compensating losses in the circuit, and a filter (15) for compensating signal changes encountered in the oscillatory circuit, the filter having an input coupled to the oscillatory circuit (L, C, Rp) and an output coupled and sending output signals to the energy source, **characterized in that** inside the energy source the output signal from the filter output is usable for changing the energy or current supplied to the oscillatory circuit to thereby actively compensate for the signal changes in the oscillatory circuit.

2. Inductive proximity sensor according to one of the preceding claims, **characterized in that** the filter comprises one of a high-pass filter, a lowpass filter, a band-pass filter or a combination thereof.

3. Inductive proximity sensor according to one of the preceding claims, **characterized in that** a voltage/current converter is placed between the filter output and a control input of the energy source for changing the supplied energy or current.

4. Inductive proximity sensor according to one of the preceding claims, **characterized in that** the energy source comprises a voltage/current converter particularly a transconductance amplifier.

5. Inductive proximity sensor according to one of the preceding claims, **characterized in that** an evaluation circuit is provided which is coupled to the oscillatory circuit.

## Revendications

1. Détecteur inductif de proximité comportant un circuit oscillant électrique (L, C, Rp), et une source d'énergie électrique (11) couplée à ce dernier pour la compensation des pertes du circuit oscillant, un filtre (15) étant prévu pour la compensation de modifications de signaux couplées dans le circuit oscillant, dont le côté entrée est couplé au circuit oscillant (L, C, Rp) et le côté sortie à la source d'énergie (11), **caractérisé en ce que**, le signal de sortie du filtre (15) peut être utilisé dans la source d'énergie (11) pour la modification de l'amenée d'énergie ou de l'amenée de courant, et par conséquent pour la compensation active de modifications de signaux introduites par couplage.

2. Détecteur de proximité selon l'une des revendications précédentes, **caractérisé en ce que** le filtre (15) est réalisé en tant que filtre passe-haut, passe-bas ou passe-bande ou en tant que combinaison de ceux-ci.

3. Détecteur de proximité selon l'une des revendications précédentes, **caractérisé en ce qu'**un convertisseur de tension / courant (13), pour la modification de l'amenée supplémentaire d'énergie ou de courant, est branché entre les sorties du filtre (15) et une sortie de commande de la source d'énergie (11).

4. Détecteur de proximité selon l'une des revendications précédentes, **caractérisé en ce que** la source d'énergie (11) comporte un convertisseur de tension / courant, notamment un amplificateur de transconductance.

5. Détecteur de proximité selon l'une des revendications précédentes, **caractérisé en ce qu'**il est prévu un circuit d'évaluation qui est couplé au circuit oscillant.
